# EUROPEAN PATENT APPLICATION

(11) **EP 4 839 035 A1**
(43) Date of publication of application: **11.11.2026**
(21) Application number: 26173215.0
(22) Date of filing: 19.04.2026
(51) Int. Cl.: H05K 7/20

(54) **AN ADAPTER FOR COOLING AN ELECTRONIC EQUIPMENT**

(30) Priority: 05.05.2025 IN 202511043499
(71) Applicant: Vertiv Corporation, Westerville, OH 43082 (US)
(72) Inventor: SHAH, Akshay D., Westerville, 43082 (US); RAUT, Dilesh Arvind, Westerville, 43082 (US)
(74) Representative: Bryn-Jacobsen, Caelia

(57) **Abstract**

An adapter **100, 300** for an electronic equipment **200** is disclosed. The adapter **100, 300** includes a housing **102, 302** having an air intake region and an air outlet region, and one or more fluid conduits **104, 304** positioned to form a mesh between the intake and outlet regions. The adapter **100, 300** includes an input port **106, 306** and an output port **108, 308** for circulating a cooling fluid through the fluid conduits **104, 304.** The cooling fluid absorbs heat from air flowing through the adapter **100, 300** before entering the air vents **202** of the electronic equipment 200. The fluid conduits **104, 304** may be interconnected or discrete and may shaped as pipes or fins. The adapter **100, 300** is mountable on a front facia of the electronic equipment **200** to enable modular, non-intrusive cooling enhancement.

## Description

### TECHNICAL FIELD

The present invention generally relates to thermal management in electronic systems. More specifically, the present invention is related to cooling enhancements for air vents used in power electronic equipment to maintain optimal thermal conditions.

### BACKGROUND

Power electronic systems such as rectifiers, converters, and power supply units form a foundational part of modern electrical infrastructure across industrial automation, telecommunications, data centers, and energy distribution networks. These systems typically operate continuously while processing substantial electrical loads, resulting in generation of considerable heat during normal operation. Effective thermal management is therefore essential to maintain operational stability, reliability, and longevity of such systems.

To prevent overheating, most power electronic systems employ air-based cooling mechanisms. A commonly adopted approach includes a fan-driven air intake system positioned at an air intake region of the equipment enclosure, configured to draw ambient air across heat-generating components. Such fan-driven air vents are widely used due to their structural simplicity, cost-effectiveness, and compatibility with modular or rack-mounted configurations. The cooling performance of these systems is primarily dependent upon the temperature, flow rate, and quality of the incoming ambient air.

Although requirement for thermal management is particularly significant in power electronic systems, similar air-based cooling architectures are also employed in other air-cooled enclosures housing electronic or electromechanical equipment. Examples include battery backup units, edge computing modules, industrial automation control panels, and telecommunications base station cabinets. In such configurations, intake air serves as the principal or sole medium of thermal regulation.

### SUMMARY OF THE INVENTION

This summary is provided to introduce aspects related to an adapter for cooling an electronic equipment. The adapter is configured to enhance cooling performance by reducing temperature of intake air before it enters equipment enclosure. The adapter includes a housing with fluid conduits through which a cooling fluid circulates to absorb heat from incoming air, thereby improving thermal management efficiency.

An adapter for an electronic equipment is disclosed. The adapter includes a housing having an air intake region and an air outlet region. The housing comprises one or more fluid conduits positioned to form a mesh between the air intake region and the air outlet region. Further the adapter includes at least one input port to introduce cooling fluid into the one or more fluid conduits and at least one outlet port to discharge the cooling fluid from the one or more fluid conduits.

The cooling fluid absorbs heat from air passing through the air intake region to the air outlet region of the housing. Further, the adapter is mountable on a front facia of the electronic equipment having one or more air vents, reducing temperature of the air passing through the air intake region and air outlet region of the housing into the air vents of the electronic equipment.

Other aspects and advantages of the invention will become apparent from the following description, taken in conjunction with the accompanying drawings, illustrating by way of example the principles of the invention.

### BRIEF DESCRIPTION OF THE DRAWINGS

The accompanying figures of the drawing, which are included to provide a further understanding of general aspects of the system/method, are incorporated in and constitute a part of this specification. These illustrative aspects of the system/method, and together with the detailed description, explain the principles of the system. No attempt is made to show structural details in more detail than is necessary for a fundamental understanding of the system and various ways in which it is practiced. The following figures of the drawing include:
**Fig. 1a** illustrates a disassembled view of an electronic equipment and an adapter for cooling the electronic equipment;
**Fig. 1b** illustrates an assembled view of the electronic equipment and the adapter for cooling the electronic equipment;
**Fig. 2a** illustrates a perspective view of the adapter and an expanded view of pipe-structured fluid conduits of the adapter;
**Fig. 2b** illustrates a perspective view of the adapter and an expanded view of fin-structured fluid conduits of the adapter; and
**Fig. 3** illustrates an assembled view of the electronic equipment and another adapter for cooling the electronic equipment, and an expanded view of the another adapter.

In the appended figures, similar components and/or features may have the same numerical reference label. Further, various components of the same type may be distinguished by following the reference label with a letter. If only the first numerical reference label is used in the specification, the description is applicable to any one of the similar components and/or features having the same first numerical reference label irrespective of the suffix.

### DESCRIPTION OF THE INVENTION

Illustrative examples are described with reference to the accompanying drawings. Wherever convenient, the same reference numbers are used throughout the drawings to refer to the same or like parts.

Conventional fan-driven air intake systems rely substantially on ambient environmental conditions, which are often suboptimal. In many deployment environments, including densely packed control rooms, outdoor telecommunications shelters, and enclosed server cabinets, the available intake air may be warm, stagnant, dust-laden, or humid. These adverse air conditions directly reduce the effectiveness of heat dissipation.

Reduced cooling efficiency leads to elevated internal temperatures within the enclosure, formation of localized thermal hotspots, and increased thermal stress on sensitive components. Over time, such thermal stress can accelerate component degradation, reduce system reliability, and increase maintenance requirements. In extreme operating scenarios, elevated temperatures may necessitate forced derating of power modules or may even result in premature system failure.

Heating problem is further exacerbated by increasing power densities in modern electronic equipment, while enclosure sizes remain constrained due to industry standards and installation limitations. Despite the critical role of intake air in maintaining acceptable thermal conditions, conventional air-vent and fan-driven cooling systems typically do not incorporate mechanisms to condition, regulate, or enhance the incoming air prior to its interaction with internal components. Consequently, there exists a need for an improved cooling mechanism for air-vent or fan-driven cooling systems that enhances thermal performance, improves reliability, extends equipment lifespan, and reduces maintenance burden.

The present invention solves the challenges faced by existing solutions by providing a modular, externally mountable adapter that conditions intake air (airflow) of electronic equipment using a cooling fluid-based heat exchange mechanism. The adapter comprises a housing having an air passage through which intake air flows before entering the electronic equipment. Embedded within the housing is a network of fluid conduits, through which a cooling fluid circulates. As air passes over the fluid conduits, heat is absorbed from the airflow, thereby reducing the temperature of the intake air before it reaches the sensitive internal components of the equipment.

By enabling localized air cooling at the point of intake, the present invention offers an efficient and easily deployable solution to mitigate thermal hotspots, extend component life, and improve the thermal margin of power electronic systems and other air-cooled enclosures. Its modular design supports easy attachment and detachment, making it suitable for both new installations and field-deployed systems.

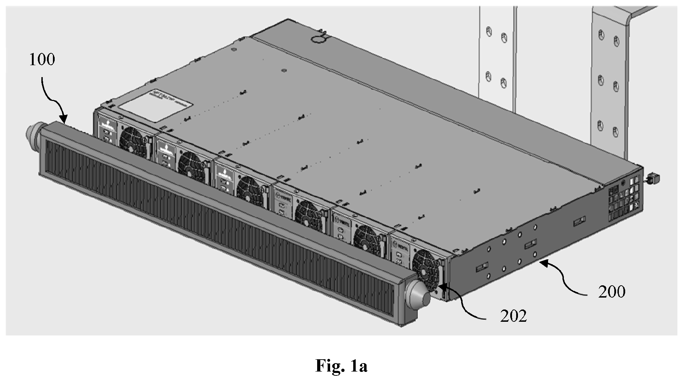

**Fig. 1a** illustrates a disassembled view of an electronic equipment **200** and an adapter **100** for cooling the electronic equipment **200.** The electronic equipment **200** may include, but is not limited to, power electronic devices such as rectifiers, DC-DC converters, inverters, power supply units (PSUs), and battery backup modules. Further, the electronic equipment **200** may include uninterruptible power supplies (UPS), power distribution units (PDUs), and other devices commonly used in telecommunications, industrial automation, or data center environments, that generate heat in operation.

Additionally, the electronic equipment **200** may also include network hardware such as servers, routers, switches, control panels in industrial systems, edge computing enclosures or base station cabinets in outdoor or remote installations. More generally, "electronic equipment" as used hereinafter may refer to any enclosed system or device that generates heat during operation, incorporates one or more air vents for the purpose of cooling internal components using airflow, and includes at least one inbuilt fan system configured to draw air through the one or more air vents.

The adapter **100** may be configured to absorb heat from the airflow being used to cool the electronic equipment **200.** Thus, the adapter **100** may be applied to any equipment where conditioning the airflow can enhance thermal management, reduce internal hotspots, and improve performance and reliability of the electronic equipment **200.**

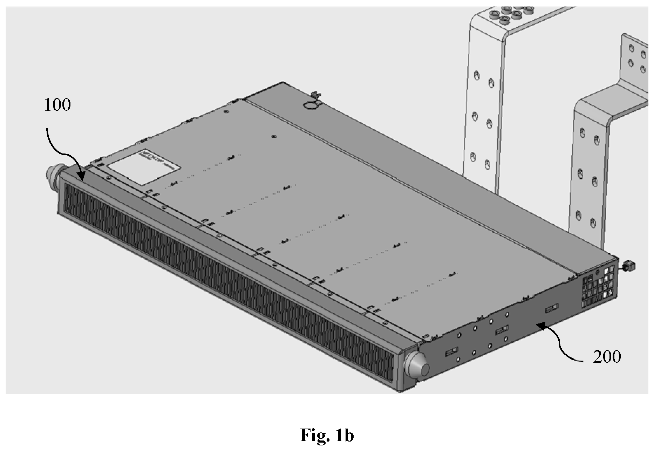

**Fig. 1b** illustrates an assembled view of the electronic equipment **200** and the adapter **100** for cooling the electronic equipment **200.** The adapter **100** may be positioned externally with respect to the electronic equipment **200,** such that the adapter **100** may align with the air vents **202** located on the front facia of the electronic equipment **200.** Retro-fitting arrangement of the adapter **100** enables a modular integration with the electronic equipment **200** without requiring internal modifications to the electronic equipment **200.**

The adapter **100** may be retrofitted to the electronic equipment **200** through a variety of attachment mechanisms, providing flexibility for integration across different equipment designs, form factors, and operational environments. The adapter **100** may include one or more snap-fit connectors that align with pre-existing slots, grooves, or anchoring features on the front facia of the electronic equipment **200.** In one implementation, the adapter **100** may be fastened using one or more of spring-loaded screws, threaded bolts, and panel mount clips, allowing for a mechanically stable connection that can withstand vibration, movement, or exposure to dynamic airflow conditions. In cases where mechanical fixtures are not feasible or where the electronic equipment **200** lacks compatible mounting interfaces, the adapter **100** may be affixed using one or more of adhesive tapes, hook-and-loop fasteners, and magnetically coupled mounting plates.

In certain implementations, the adapter **100** may further include one or more sealing elements positioned between the housing **102** and the front facia of the electronic equipment **200.** Such sealing elements may include gaskets, compressible foam layers, elastomeric seals, or airflow shrouds configured to minimize bypass airflow around the housing **102.** The sealing interface may ensure that substantially all intake air drawn by an inbuilt fan system of the electronic equipment **200** passes through one or more fluid conduits of the adapter **100** for effective thermal conditioning.

In one implementation, the adapter **100** may also be designed with one or more of adjustable brackets and universal mounting frames that can be aligned with a wide range of facia geometries, enabling compatibility across different makes and models of electronic equipment **200.**

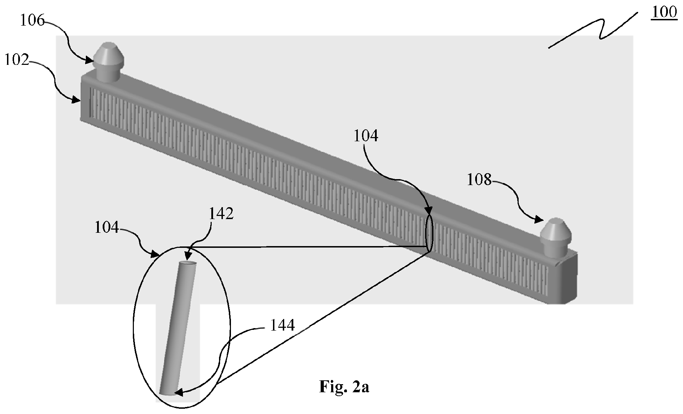

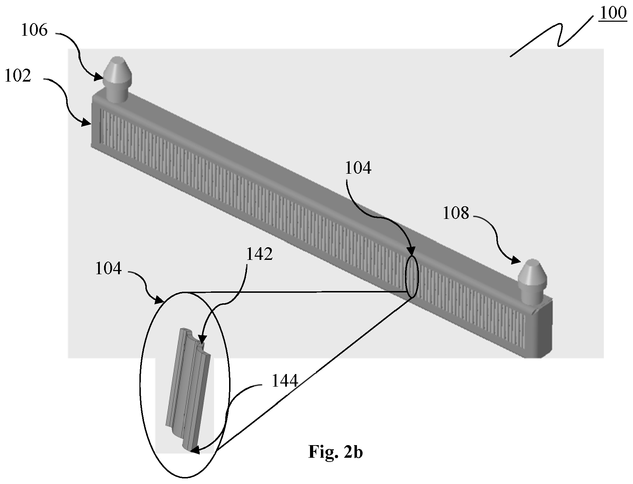

Now referring to **Figs. 2a** and **2b****,** the adapter **100** may include a housing **102.** The housing **102** may include an air intake region and an air outlet region, positioned opposite to each other. Further, the housing **102** may include one or more fluid conduits **104** positioned to form a mesh between the air intake region and the air outlet region of the housing **102.**

In the context of the present disclosure, "mesh" refers broadly to any structured or distributed arrangement of the one or more fluid conduits **104** that allows airflow to pass between and around the one or more fluid conduits **104** while facilitating heat exchange between the airflow and the cooling fluid. The mesh may include, but is not limited to, a grid arrangement, lattice configuration, staggered array, parallel array, cross-flow configuration, serpentine layout, matrix distribution, manifold-fed array, or any other structured conduit distribution that provides a distributed thermal interaction surface within the air passage. The conduits may be oriented vertically, horizontally, diagonally, or in mixed orientations depending on airflow direction and cooling requirements.

Shape of each of the fluid conduits **104** may be at least one of, a pipe structure (as shown in **Fig. 2a****)** and a finned structure (as shown in **Fig. 2b****).** Further, the fluid conduits **104** may be hollow. Each of the fluid conduits **104** may include a first opening **142** for cooling fluid inlet and a second opening **144** for cooling fluid outlet. Furthermore, the fluid conduits **104** may be interconnected with each other, via the housing **102.** Selection between a finned structure and a pipe structure for the fluid conduits **104** within the adapter **100** depends on cooling requirements and design constraints of electronic equipment **200.** A finned structure may offer a greater surface area for heat exchange between a cooling fluid inside the fluid conduits **104** and the intake air, which can result in more uniform cooling and enhanced thermal transfer efficiency across the adapter **100.**

On the other hand, a pipe structure, particularly when densely packed, may facilitate higher flow rates of the cooling fluid and targeted thermal contact. Additionally, pipe-based designs may offer simpler manufacturability and maintenance in certain configurations. Accordingly, the adapter **100** may be implemented with either a pipe or a finned structure depending on thermal load, fluid type, spatial constraints, and airflow dynamics.

The one or more fluid conduits **104** may be formed from thermally conductive materials including, but not limited to, aluminum, copper, brass, stainless steel, thermally conductive polymers, composite materials, or combinations thereof. The one or more fluid conduits **104** may further include surface treatments or coatings such as corrosion-resistant coatings, dielectric coatings, anodized layers, or hydrophobic finishes to enhance durability, electrical isolation, or moisture management.

In various implementations, airflow through the housing 102 may interact with the fluid conduits **104** in different flow relationships, including axial flow, cross-flow, counter-flow, or co-flow configurations relative to the cooling fluid flowing within the conduits **104.** The arrangement of the conduits **104** may be selected to promote laminar airflow for reduced pressure drop or to induce controlled turbulence to enhance convective heat transfer. The housing **102** may further include internal baffles, flow straighteners, or turbulence-inducing features to optimize heat exchange efficiency while maintaining acceptable airflow resistance.

Further, the adapter **100** may include at least one input port **106** to introduce the cooling fluid into the one or more fluid conduits **104** and at least one outlet port **108** to discharge the cooling fluid from the one or more fluid conduits **104.** The cooling fluid absorbs heat from the airflow passing through the air intake region to the air outlet region of the housing **102.** The cooling fluid may include but is not limited to, thermally conductive liquids such as water, glycol-based solutions, dielectric fluids, and refrigerants, as well as gases such as air, carbon dioxide, and inert gases like nitrogen.

Selection of the cooling fluid may depend on specific application requirements, including thermal conductivity, pressure and temperature tolerance, electrical insulation properties, environmental considerations, and compatibility with materials of the fluid conduits **104** and other components of the adapter **100.**

In certain examples, where the cooling fluid reduces the intake air temperature below ambient dew point conditions, the adapter **100** may include condensation management features. Such features may include condensate collection channels, drainage passages, drip trays, moisture barriers, hydrophobic coatings on conduit surfaces, or insulated conduit sections to control moisture accumulation. These features may prevent liquid accumulation from entering the electronic equipment **200** while maintaining effective thermal conditioning of the intake air.

The input port **106** and the output port **108** may be coupled to a fluid circulation pump via a heat exchanger to enable continuous flow and thermal regulation of the cooling fluid through the one or more fluid conduits **104** within the adapter **100.** The fluid circulation pump may be configured to maintain a predetermined flow rate and pressure to ensure effective heat transfer from the intake air to the cooling fluid. The fluid circulation pump may include, but is not limited to, a centrifugal pump, a diaphragm pump, a peristaltic pump, and a gear pump, depending on the nature of the cooling fluid, pressure and flow requirements for cooling the electronic equipment **200.**

The heat exchanger may be operatively connected to the fluid circulation pump and may be positioned externally or remotely from the adapter **100.** The heat exchanger may function to dissipate heat absorbed from the cooling fluid before it is recirculated back through the input port **106.** The heat exchanger may include, but is not limited to, a finned radiator, forced-air unit, and liquid-to-liquid exchanger, depending on the cooling medium and space constraints.

In alternative implementations, circulation of the cooling fluid may be achieved through passive mechanisms, including thermosiphon circulation, gravity-assisted flow, phase-change loops, or other natural convection-based arrangements. In such implementations, the adapter **100** may operate without an active pump while still enabling heat absorption from the intake airflow.

The adapter **100** may be mountable on a front facia of the electronic equipment **200** having one or more air vents **202** (as shown in the **Fig. 1a** and **1b****),** reducing temperature of the airflow passing through the fluid conduits **104** in the housing **102** into the air vents **202** of the electronic equipment **200.**

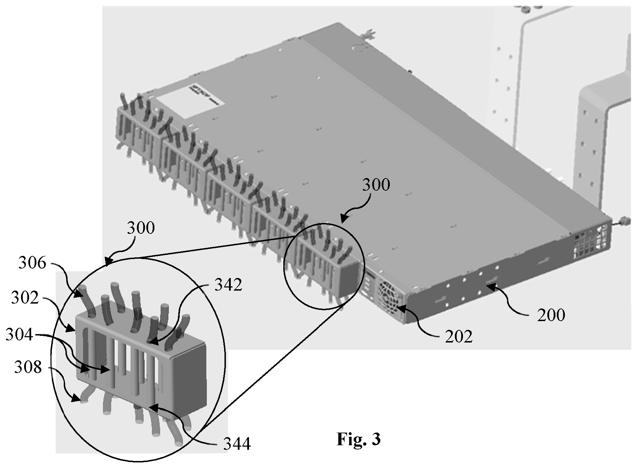

**Fig. 3** illustrates an assembled view of the electronic equipment **200** and another adapter **300** for cooling the electronic equipment **200,** and an expanded view of the adapter **300.** The adapter **300** may be configured to absorb heat from the airflow being used to cool the electronic equipment **200.** Thus, the adapter **300** may be applied to any equipment where conditioning the airflow can enhance thermal management, reduce internal hotspots, and improve performance and reliability of the electronic equipment **200.**

One or more adapters **300** may be positioned externally with respect to the electronic equipment **200,** such that each of the adapter **300** may align with each of the air vents **202** located on the front facia of the electronic equipment **200.** Retro-fitting arrangement of the adapter **300** enables a modular integration with the electronic equipment **200** without requiring internal modifications to the electronic equipment **200.**

The adapter **300** may be retrofitted to the electronic equipment **200** through a variety of attachment mechanisms, providing flexibility for integration across different equipment designs, form factors, and operational environments. The adapter **300** may include one or more snap-fit connectors that align with pre-existing slots, grooves, or anchoring features on the front facia of the electronic equipment **200.** In one implementation, the adapter **300** may be fastened using one or more of spring-loaded screws, threaded bolts, and panel mount clips, allowing for a mechanically stable connection that can withstand vibration, movement, or exposure to dynamic airflow conditions. In cases where mechanical fixtures are not feasible or where the electronic equipment **200** lacks compatible mounting interfaces, the adapter **300** may be affixed using one or more of adhesive tapes, hook-and-loop fasteners, and magnetically coupled mounting plates.

In one implementation, the adapter **300** may also be designed with one or more of, adjustable brackets and universal mounting frames that can be aligned with a wide range of facia geometries, enabling compatibility across different makes and models of electronic equipment **200.**

Further, as shown in **Fig. 3****,** the adapter **300** may include a housing **302.** The housing **302** may include an air intake region and an air outlet region, positioned opposite to each other. Further, one or more fluid conduits **304** may be positioned within the housing **302** to form a mesh between the air intake region and the air outlet region of the housing **302.**

Shape of each of the fluid conduits **304** may be at least one of, a pipe structure (as shown in **Fig. 3****)** and a finned structure (not shown in **Fig. 3****).** Selection between a finned structure and a pipe structure for the fluid conduits **304** within the adapter **300** depends on cooling requirements and design constraints of electronic equipment **200.** A finned structure may offer a greater surface area for heat exchange between a cooling fluid inside the fluid conduits **304** and the intake air, which can result in more uniform cooling and enhanced thermal transfer efficiency across the adapter **300.**

On the other hand, a pipe structure, particularly when densely packed, may facilitate higher flow rates of the cooling fluid and targeted thermal contact. Additionally, pipe-based designs may offer simpler manufacturability and maintenance in certain configurations. Accordingly, the adapter **300** may be implemented with either a pipe or a finned structure depending on thermal load, fluid type, spatial constraints, and airflow dynamics.

The one or more fluid conduits **304** may be formed from thermally conductive materials including, but not limited to, aluminum, copper, brass, stainless steel, thermally conductive polymers, composite materials, or combinations thereof. The one or more fluid conduits **304** may further include surface treatments or coatings such as corrosion-resistant coatings, dielectric coatings, anodized layers, or hydrophobic finishes to enhance durability, electrical isolation, or moisture management.

Further, the fluid conduits **304** may be hollow. Furthermore, the fluid conduits **304** may be discrete and disconnected to each other. Each of the fluid conduits **304** may include a first opening **342** for cooling fluid inlet and a second opening **344** for cooling fluid outlet. Further, each first opening **342** may be connected to an input port **306** to receive the cooling fluid. Furthermore, each second opening **344** may be connected to an output port **308** to flush the cooling fluid after use.

The cooling fluid absorbs heat from the airflow passing through the air intake region to the air outlet region of the housing **302.** The cooling fluid may include, but is not limited to, thermally conductive liquids such as water, glycol-based solutions, dielectric fluids, and refrigerants, as well as gases such as air, carbon dioxide, and inert gases like nitrogen. Selection of the cooling fluid may depend on specific application requirements, including thermal conductivity, pressure and temperature tolerance, electrical insulation properties, environmental considerations, and compatibility with materials of the fluid conduits **304** and other components of the adapter **300.**

In certain examples, where the cooling fluid reduces the intake air temperature below ambient dew point conditions, the adapter **300** may include condensation management features. Such features may include condensate collection channels, drainage passages, drip trays, moisture barriers, hydrophobic coatings on conduit surfaces, or insulated conduit sections to control moisture accumulation. These features may prevent liquid accumulation from entering the electronic equipment **200** while maintaining effective thermal conditioning of the intake air.

The input port **306** and the output port **308** may be coupled to a fluid circulation pump via a heat exchanger to enable continuous flow and thermal regulation of the cooling fluid through the one or more fluid conduits **304** within the adapter **300.** The fluid circulation pump may be configured to maintain a predetermined flow rate and pressure to ensure effective heat transfer from the intake air to the cooling fluid. The fluid circulation pump may include, but is not limited to, a centrifugal pump, a diaphragm pump, a peristaltic pump, and a gear pump, depending on the nature of the cooling fluid, pressure and flow requirements for cooling the electronic equipment **200.**

The heat exchanger may be operatively connected to the fluid circulation pump and may be positioned externally or remotely from the adapter **300.** The heat exchanger may function to dissipate heat absorbed from the cooling fluid before it is recirculated back through the input port **306.** The heat exchanger may include, but is not limited to, a finned radiator, forced-air unit, and liquid-to-liquid exchanger, depending on the cooling medium and space constraints.

In alternative implementations, circulation of the cooling fluid may be achieved through passive mechanisms, including thermosiphon circulation, gravity-assisted flow, phase-change loops, or other natural convection-based arrangements. In such implementations, the adapter **300** may operate without an active pump while still enabling heat absorption from the intake airflow.

In certain implementations, the adapter **100** and the adapter **300** may further include one or more sensors configured to monitor parameters including intake air temperature, humidity, airflow rate, coolant temperature, or coolant flow rate. A controller may be operatively coupled to the fluid circulation pump to regulate coolant flow based on sensed operating conditions, thereby optimizing thermal performance while minimizing energy consumption.

In certain implementations, adapter **100** and adapter **300** represent alternative conduit architectures within the broader inventive concept. Adapter **100** may include interconnected fluid conduits **104** forming a continuous coolant distribution network within the housing **102,** enabling shared coolant circulation across the conduit array. In contrast, adapter **300** may include discrete and mutually disconnected fluid conduits **304,** each having independent inlet and outlet connections, thereby enabling separate coolant flow paths through individual conduits. Such architectural variations allow selection between distributed coolant equalization and independently controlled conduit cooling, depending on application requirements.

The methods, systems, devices, graphs, and/or tables discussed herein are examples. Various examples may omit, substitute, or add various procedures or components as appropriate. For instance, in alternative examples, the methods may be performed in an order different from that described, and/or various stages may be added, omitted, and/or combined. Also, features described with respect to certain examples may be combined in various other examples. Different aspects and elements of the examples may be combined in a similar manner. Also, technology evolves and, thus, many of the elements are examples and do not limit the scope of the disclosure or claims. Additionally, the techniques discussed herein may provide differing results with different types of context awareness classifiers.

Unless defined otherwise, all technical and scientific terms used herein have the same meaning as commonly or conventionally understood. As used herein, the articles "a" and "an" refer to one or to more than one (i.e., to at least one) of the grammatical object of the article. By way of example, "an element" means one element or more than one element. "About" and/or "approximately" as used herein when referring to a measurable value such as an amount, a temporal duration, and the like, encompasses variations of +20% or +10%, +5%, or +0.1% from the specified value, as such variations are appropriate to in the context of the systems, devices, circuits, methods, and other implementations described herein. "Substantially" as used herein when referring to a measurable value such as an amount, a temporal duration, a physical attribute (such as frequency), and the like, also encompasses variations of ±20% or ±10%, ±5%, or ±0.1% from the specified value, as such variations are appropriate to in the context of the systems, devices, circuits, methods, and other implementations described herein.

As used herein, including in the claims, "and" as used in a list of items prefaced by "at least one of" or "one or more of" indicates that any combination of the listed items may be used. For example, a list of "at least one of A, B, and C" includes any of the combinations A or B or C or AB or AC or BC and/or ABC (i.e., A and B and C). Furthermore, to the extent more than one occurrence or use of the items A, B, or C is possible, multiple uses of A, B, and/or C may form part of the contemplated combinations. For example, a list of "at least one of A, B, and C" may also include AA, AAB, AAA, BB, etc.
Further examples are set out in the clauses below:
1. An adapter (100, 300) for an electronic equipment (200), comprises:
   a housing (102, 302) having an air intake region and an air outlet region, the housing (102, 302) comprises one or more fluid conduits (104, 304) positioned to form a mesh between the air intake region and the air outlet region;
   at least one input port (106, 306) to introduce cooling fluid into the one or more fluid conduits (104, 304) and at least one outlet port (108, 308) to discharge the cooling fluid from the one or more fluid conduits (104, 304),
      wherein the cooling fluid absorbs heat from air passing through the air intake region to the air outlet region of the housing (102, 302); and
      wherein the adapter (100, 300) is mountable on a front facia of the electronic equipment (200) having one or more air vents (202), reducing temperature of the air passing through the air intake region and air outlet region of the housing (102, 302) into the air vents (202) of the electronic equipment (200).
2. The adapter (100, 300) as claimed in clause 1, wherein each of the fluid conduits (104, 304) includes a first opening for fluid inlet (142, 342) and a second opening (144, 344) for fluid outlet.
3. The adapter (100) as claimed in clause 1 or 2, wherein the one or more fluid conduits (104) are interconnected with each other to form a continuous fluid path between the air intake region and the air outlet region of the housing (102).
4. The adapter (100) of any one of clauses 1-3, wherein the one or more fluid conduits (104) are selected from a group consisting of: a pipe structure, and a finned structure, wherein the finned structure provides an increased surface area for heat exchange between the cooling fluid and the air passing through the air intake region to the air outlet region of the housing (102).
5. The adapter (300) as claimed in any one of the preceding clauses, wherein each of the one or more fluid conduits (304) is discrete and independently connected to the input port (306) and the output port (308) to provide separate coolant flow paths.
5A. The adapter (300) as claimed in any one of the preceding clauses, wherein each of the one or more fluid conduits (304) is discrete.
6. The adapter (100, 300) as claimed in any one of the preceding clauses, wherein the input port (106, 306) and the output port (108, 308) are coupled to a fluid circulation pump via a heat exchanger.
7. The adapter (100, 300) as claimed in any one of the preceding clauses, wherein the housing (102, 302) comprises at least one airflow directing element selected from baffles, flow straighteners, or turbulence-inducing features configured to enhance convective heat transfer.
8. The adapter (100, 300) as claimed in any one of the preceding clauses, further comprising at least one sealing element positioned between the housing (102, 302) and the front facia of the electronic equipment (200) to reduce bypass airflow around the housing (102, 302).
9. The adapter (100, 300) as claimed in any one of the preceding clauses, wherein the one or more fluid conduits (104, 304) are formed from thermally conductive materials including at least one of aluminum, copper, stainless steel, thermally conductive polymer, or composite material.

While illustrative and presently preferred examples of the disclosed systems, methods, and/or machine-readable media have been described in detail herein, it is to be understood that the inventive concepts may be otherwise variously embodied and employed, and that the appended claims are intended to be construed to include such variations, except as limited by the prior art. While the principles of the disclosure have been described above in connection with specific apparatuses and methods, it is to be clearly understood that this description is made only by way of example and not as a limitation on the scope of the disclosure.

## Claims

1. An adapter (100, 300) for an electronic equipment (200), comprises:
a housing (102, 302) having an air intake region and an air outlet region, the housing (102, 302) comprises one or more fluid conduits (104, 304) positioned to form a mesh between the air intake region and the air outlet region;
at least one input port (106, 306) to introduce cooling fluid into the one or more fluid conduits (104, 304) and at least one outlet port (108, 308) to discharge the cooling fluid from the one or more fluid conduits (104, 304),
wherein the cooling fluid absorbs heat from air passing through the air intake region to the air outlet region of the housing (102, 302); and
wherein the adapter (100, 300) is mountable on a front facia of the electronic equipment (200) having one or more air vents (202), reducing temperature of the air passing through the air intake region and air outlet region of the housing (102, 302) into the air vents (202) of the electronic equipment (200).

2. The adapter (100, 300) as claimed in claim 1, wherein each of the fluid conduits (104, 304) includes a first opening for fluid inlet (142, 342) and a second opening (144, 344) for fluid outlet.

3. The adapter (100) as claimed in claim 1 or 2, wherein the one or more fluid conduits (104) are interconnected with each other to form a continuous fluid path between the air intake region and the air outlet region of the housing (102).

4. The adapter (100) of any one of the preceding claims, wherein the one or more fluid conduits (104) are selected from a group consisting of: a pipe structure, and a finned structure, wherein the finned structure provides an increased surface area for heat exchange between the cooling fluid and the air passing through the air intake region to the air outlet region of the housing (102).

5. The adapter (300) as claimed in any one of the preceding claims, wherein each of the one or more fluid conduits (304) is discrete and independently connected to the input port (306) and the output port (308) to provide separate coolant flow paths.

6. The adapter (100, 300) as claimed in any one of the preceding claims, wherein the input port (106, 306) and the output port (108, 308) are coupled to a fluid circulation pump via a heat exchanger.

7. The adapter (100, 300) as claimed in any one of the preceding claims, wherein the housing (102, 302) comprises at least one airflow directing element selected from baffles, flow straighteners, or turbulence-inducing features configured to enhance convective heat transfer.

8. The adapter (100, 300) as claimed in any one of the preceding claims, further comprising at least one sealing element positioned between the housing (102, 302) and the front facia of the electronic equipment (200) to reduce bypass airflow around the housing (102, 302).

9. The adapter (100, 300) as claimed in any one of the preceding claims, wherein the one or more fluid conduits (104, 304) are formed from thermally conductive materials including at least one of aluminum, copper, stainless steel, thermally conductive polymer, or composite material.
